Europäisches Patentamt

European Patent Office

Office européen des brevets

(19)

(11) Numéro de publication : **0 538 122 B1**

(12) **FASCICULE DE BREVET EUROPEEN**

(45) Date de publication du fascicule du brevet :
03.05.95 Bulletin 95/18

(51) Int. Cl.$^6$ : **H01S 3/25,** G02F 3/00

(21) Numéro de dépôt : **92402806.1**

(22) Date de dépôt : **14.10.92**

(54) **Générateur de fonctions logiques utilisant une transposition optique dans une diode laser à contre-réaction distribuée.**

(30) Priorité : **16.10.91 FR 9112763**

(43) Date de publication de la demande :
**21.04.93 Bulletin 93/16**

(45) Mention de la délivrance du brevet :
**03.05.95 Bulletin 95/18**

(84) Etats contractants désignés :
**DE GB**

(56) Documents cités :
**ELECTRONICS LETTERS. vol. 25, no. 22, 26
Octobre 1989, Stevenage, Herts, GB; pages
1485-1486;H. NOBUHARA et al.:"Optical
exclusive-or operation using tunable wavelength conversion laser"
ELECTRONICS LETTERS. vol. 25, no. 20, 28
Septembre 1989, Stevenage, Herts, GB;pages
1360 - 1362;K. INOUE et al.:"Wavelength
conversion for FM light using light injection
induced frequency shift in DFB-LD"
PATENT ABSTRACTS OF JAPAN vol. 13, no.
23 (E-705)19 Janvier 1989; & JP-A-63 226 990
PATENT ABSTRACTS OF JAPAN vol. 14, no.
269 (P-1059)11 Juin 1990; & JP-A-20 77 030**

(56) Documents cités :
**IEEE JOURNAL OF QUANTUM ELECTRONICS.
vol. 24, no. 11, Novembre 1988, New York, US;
pages 2153-2159;H.KAWAGUCHI et al.:
"Tunable optical wavelength conversion
using an optically triggerable multielectrode
distributed feedback laser diode"**

(73) Titulaire : **FRANCE TELECOM
Etablissement autonome de droit public,
6, Place d'Alleray
F-75015 Paris (FR)**

(72) Inventeur : **Auffret, René**
**48 Route de Kernu Louannec
F-22700 Perros Guirec (FR)**
Inventeur : **Pottier, Patrice**
**Le Roudour Servel
F-22300 Lannion (FR)**
Inventeur : **Chawki, Mouhammad J.**
**34 Boulevard d'armor N 212
F-22300 Lannion (FR)**
Inventeur : **Claveau, Georges**
**La Gare
FR-22450 Camlez (FR)**

(74) Mandataire : **Dubois-Chabert, Guy et al**
**c/o BREVATOME
25, rue de Ponthieu
F-75008 Paris (FR)**

## Description

La présente invention concerne un générateur de fonctions logiques optiques.

Elle s'applique notamment à la réalisation de dispositifs de commutation optique ainsi qu'à la réalisation de dispositifs de calcul optique.

On connaît déjà par le document

(1) Optical exclusive - OR operation using tunable wavelength conversion laser diode, H. Nobuhara, K. Kondo et S. Yamakoshi, Electronics letters, 26 octobre 1989, vol.25, n°22, p.1485 et 1486 un dispositif permettant de réaliser l'opération logique OU EXCLUSIF sous forme optique.

Ce dispositif connu présente des inconvénients :
- il utilise une diode laser dont la constitution est très compliquée (cette diode laser comporte quatre électrodes de commande et un absorbant saturable), et
- il est capable d'effectuer seulement une opération logique (OU EXCLUSIF).

La présente invention a pour but de remédier aux inconvénients précédents en proposant un générateur de fonctions logiques optiques
- qui est réalisable avec une diode laser à contre-réaction distribuée ("Distributed Feedback Laser Diode") de type classique, à une ou deux électrodes de polarisation et
- qui, contrairement au dispositif décrit dans le document (1), est capable de fournir en sortie une fonction logique, sous forme optique, qui est reconfigurable, c'est-à-dire que l'on peut choisir cette fonction logique parmi plusieurs fonctions logiques réalisables avec le générateur objet de la présente invention.

Pour ce faire, ce générateur utilise une transposition optique dans la diode laser à contre-réaction distribuée qu'il comporte ainsi qu'un filtre optique accordable en fréquence.

De façon précise, la présente invention a pour objet un générateur de fonctions logiques optiques conformément à la revendication 1.

Pour un bon fonctionnement du générateur de fonctions logiques objet de la présente invention, il est préférable que la direction de polarisation de chacun des signaux optiques numériques qui arrivent à l'entrée de la diode laser à contre-réaction distribuée soit dans le plan de polarisation de cette diode laser.

De préférence, cette diode laser à contre-réaction distribuée comporte deux électrodes de polarisation.

Il est alors facile de choisir les deux courants électriques, permettant respectivement la polarisation des deux électrodes, de telle manière que la diode laser soit monomode.

Le filtre optique que comporte le générateur objet de la présente invention peut être un interféromètre de Perot Fabry accordable.

Mais, de préférence, ce filtre optique est une diode laser auxiliaire à contre-réaction distribuée qui est munie de moyens aptes à polariser cette diode laser auxiliaire au-dessous de son courant de seuil.

On a ainsi moins de pertes optiques qu'avec l'interféromètre de Perot Fabry.

Enfin, le nombre de sources de signaux optiques numériques peut être égal à 2, la diode laser, qui reçoit ces signaux par l'intermédiaire du coupleur, émettant ainsi des signaux à trois fréquences optiques différentes, le filtre optique fournissant alors en sortie, suivant celle des trois fréquences qui est sélectionnée, l'une des fonctions logiques ET, NON ET et OU EXCLUSIF sous forme optique.

La présente invention sera mieux comprise à la lecture de la description d'exemples de réalisation donnés ci-après à titre purement indicatif et nullement limitatif, en faisant référence aux dessins annexés sur lesquels :
- la figure 1 illustre schématiquement le principe d'une transposition optique par glissement de la fréquence d'émission d'une diode laser à contre-réaction distribuée,
- la figure 2 est ,une vue schématique d'un mode de réalisation particulier du générateur de fonctions logiques objet de la présente invention,
- la figure 3 montre un exemple de signal optique numérique susceptible d'être fourni par l'une des deux sources que comporte le générateur schématiquement représenté sur la figure 2,
- la figure 4 montre un exemple de signal optique numérique susceptible d'être fourni par l'autre source que comporte ce générateur,
- la figure 5 montre la réponse en fréquence de la diode laser à contre-réaction distribuée que comporte ce générateur de la figure 2, lorsque cette diode laser reçoit les signaux représentés sur les figures 3 et 4,
- la figure 6 représente schématiquement un interféromètre de Perot Fabry accordable qui peut être utilisé en tant que filtre optique dans ce générateur, et
- la figure 7 représente schématiquement une diode laser auxiliaire à contre-réaction distribuée qui peut également être utilisée en tant que filtre optique dans le générateur de la figure 2.

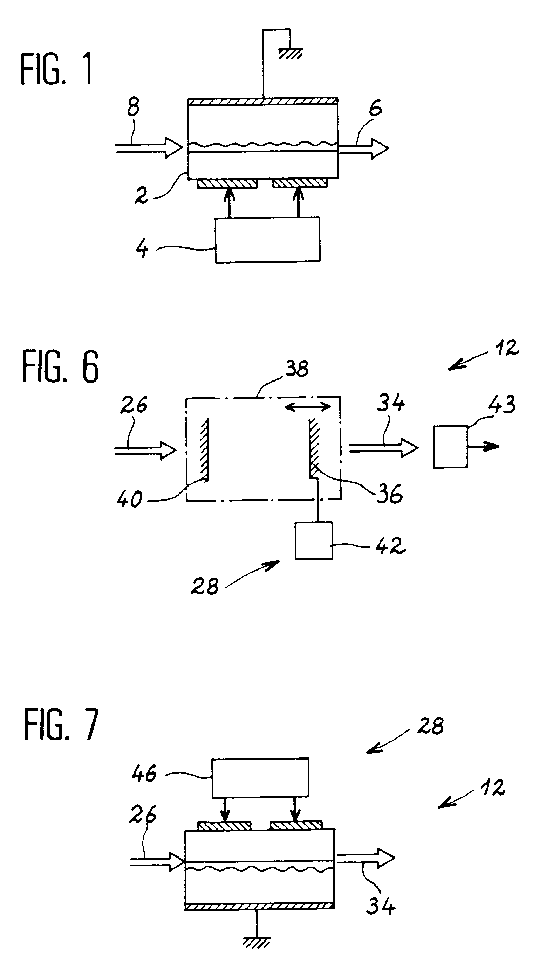

On explique ci-après, à l'aide de la figure 1, le principe de la transposition optique par glissement de la fréquence d'émission d'une diode laser à contre-réaction distribuée.

Une telle transposition optique est utilisée dans la présente invention et mentionnée dans le document

(2) Wavelength conversion for FM light using light injection induced frequency shift in DFB-LD, K. INOUE et N. TAKATO, Electronics letters, 28 Septembre 1989, vol.25, n°20, p.1360 à 1362.

Etant donné une diode laser à contre-réaction distribuée 2 qui possède par exemple deux électrodes de polarisation, on munit cette diode laser 2 de moyens de polarisation électrique 4 prévus pour appliquer à ces électrodes des courants de polarisation constants, permettant de rendre la diode laser 2 monomode et d'obtenir une émission laser.

Alors la diode laser émet un faisceau lumineux 6, ou faisceau de sortie, dont la longueur d'onde est notée lo (longueur d'onde de repos de la diode laser).

Si l'on injecte dans la couche active de la diode laser 2 un faisceau lumineux 8, il se produit un glissement de la fréquence optique du faisceau de sortie 6.

Si la puissance lumineuse du faisceau incident 8 est modulée entre 0 et une valeur maximale Pm, alors la fréquence optique du faisceau de sortie 6 varie de façon continue entre deux valeurs dont la plus faible correspond à la longueur d'onde de repos lo.

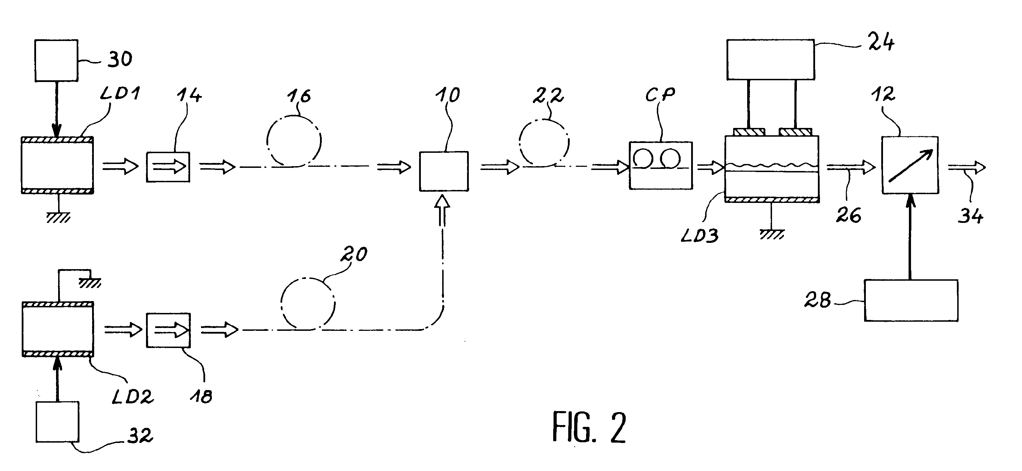

On a représenté schématiquement sur la figure 2 un mode de réalisation particulier du générateur de fonctions logiques objet de la présente invention.

Le générateur représenté sur la figure 2 comprend :
- deux diodes lasers monomodes LD1 et LD2,
- un coupleur optique 10 à deux entrées et une sortie (coupleur de type "2 vers 1"),
- une diode laser à contre-réaction distribuée LD3, et
- un filtre optique 12 qui est accordable en fréquence.

La diode laser LD1, à la sortie de laquelle est placé un isolateur optique 14, est reliée par une fibre optique 16 à une entrée du coupleur optique 10.

De même, la diode laser LD2, à la sortie de laquelle est placé un isolateur optique 18, est reliée par une fibre optique 20 à l'autre entrée du coupleur optique 10.

La lumière susceptible d'être fournie par la sortie du coupleur optique 10 est envoyée à la diode laser LD3 par l'intermédiaire d'une fibre optique 22 et injectée dans la couche active de cette diode laser LD3.

La diode laser LD3, qui comporte deux électrodes de polarisation, est munie de moyens de commande 24 prévus pour envoyer respectivement à ces électrodes deux courants de polarisation constants, choisis de façon que la diode laser LD3 soit monomode et fournisse en sortie un faisceau laser 26.

A la place de la diode laser LD3 à deux électrodes, on pourrait utiliser une diode laser à contre-réaction distribuée à une seule électrode de polarisation mais il faudrait alors lui faire subir un traitement anti-reflet pour la rendre monomode (au cas où elle ne le serait pas).

Tant que la diode laser LD3 ne reçoit aucun signal lumineux en provenance du coupleur optique 10, la longueur d'onde du faisceau lumineux de sortie 26 est la longueur d'onde de repos L0 de la diode laser LD3.

La fréquence optique correspondant à cette longueur d'onde L0 est notée F0.

Le filtre optique 12, qui est accordable en fréquence, est placé à la sortie de la diode laser LD3 et prévu pour sélectionner une fréquence optique parmi les fréquences optiques des signaux lumineux susceptibles d'être fournis par la diode laser LD3.

Ce filtre optique 10 est commandé par des moyens appropriés 28.

Les diodes lasers LD1 et LD2 sont respectivement commandées par des générateurs de signaux électriques 30 et 32.

Dans l'exemple décrit, il s'agit de signaux numériques pseudo-aléatoires qui sont synchrones et ont le même débit.

Ainsi les diodes lasers LD1 et LD2 émettent respectivement des signaux optiques numériques S1 et S2 qui sont synchrones et ont le même débit.

Ces signaux optiques sont mélangés par le coupleur optique 10 et sont injectés simultanément dans la couche active de la diode laser LD3.

On précise qu'un contrôleur de polarisation CP est placé à l'entrée de la diode laser LD3 afin de donner aux signaux S1 et S2 sortant de la fibre optique 22 une direction de polarisation située dans le plan de polarisation de la diode laser LD3 (plan de la couche active de cette diode laser LD3).

Chacun des signaux optiques S1 et S2 est une suite de niveaux hauts (niveaux logiques 1) et de niveaux bas (niveaux logiques 0).

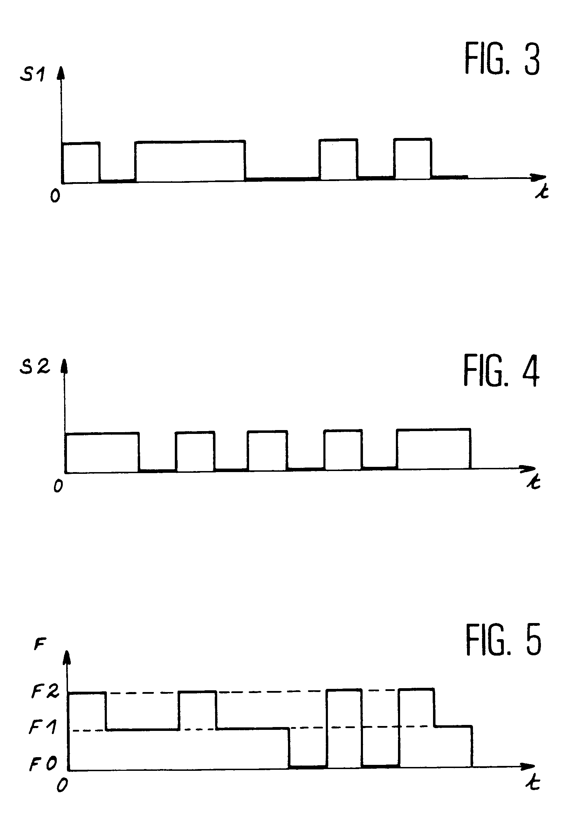

Un exemple de signal optique numérique S1 fourni par la diode laser LD1 est représenté sur la figure 3.

De même, un exemple de signal optique numérique S2 fourni par la diode laser LD2 est représenté sur la figure 4.

Les axes des temps représentés sur ces figures 3 et 4 ont la même origine 0.

On voit donc sur la figure 3, les variations, en fonction du temps $t$, de la puissance lumineuse fournie par la diode laser LD1 et, sur la figure 4, les variations, en fonction du temps $\underline{t}$, de la puissance lumineuse fournie par la diode laser LD2.

On comprend que la puissance lumineuse injectée dans la diode laser LD3 varie au cours du temps.

Trois cas se présentent :

a) deux niveaux logiques 0, provenant respectivement des diodes lasers LD1 et LD2, arrivent simultanément sur la diode laser LD3,

b) un niveau logique 0, provenant de l'une des diodes lasers LD1 et LD2, et un niveau logique 1, provenant de l'autre de ces diodes lasers LD1 et LD2, arrivent simultanément sur la diode laser LD3, et

c) deux niveaux logiques 1, provenant respectivement des diodes lasers LD1 et LD2, arrivent simultanément sur la diode laser LD3.

Dans le cas a), la puissance lumineuse injectée dans la diode laser LD3 est nulle.

En conséquence, la fréquence optique du faisceau lumineux 26 émis par cette diode laser LD3 est la fréquence de repos F0 de la diode laser LD3.

Dans le cas b), la puissance lumineuse injectée dans cette diode laser LD3 n'est pas nulle et la fréquence du signal lumineux fourni par la diode laser LD3 glisse jusqu'à une valeur F1 supérieure à F0.

Enfin, dans le cas c), la puissance lumineuse injectée dans la diode laser LD3 est la puissance lumineuse maximale que l'on puisse obtenir avec les signaux S1 et S2.

La fréquence optique du signal lumineux 26 fourni par la diode laser LD3 glisse, dans ce cas c), jusqu'à une valeur F2 supérieure à F1.

On obtient donc, à la sortie de la diode laser LD3, un signal optique numérique dont la fréquence optique F passe successivement de l'une des valeurs F0, F1 et F2 à une autre de ces valeurs au cours du temps $\underline{t}$.

Sur la figure 5, on a représenté la réponse en fréquence F, en fonction du temps $\underline{t}$, de la diode laser LD3, cette réponse en fréquence correspondant aux signaux S1 et S2 donnés à titre d'exemple sur les figures 3 et 4.

L'origine 0 de l'axe des temps $\underline{t}$ de la figure 5 est confondu avec l'origine de l'axe des temps des figures 3 et 4.

La table de vérité, qui est donnée à la fin de la présente description et qui correspond à la figure 5, montre le signal optique numérique 34 que l'on obtient à la sortie du filtre optique accordable en fréquence 12 suivant que ce filtre optique sélectionne la fréquence F0, la fréquence F1 ou la fréquence F2.

Cette table de vérité montre que le filtre optique 12 permet de sélectionner l'une des trois fonctions logiques ET (AND dans les articles en langue anglaise), NON ET (NAND dans les articles en langue anglaise) et OU EXCLUSIF (XOR dans les articles en langue anglaise).

Plus précisément, lorsque la fréquence F0 est sélectionnée, le signal optique numérique 34 fourni par le filtre optique 12 correspond à la fonction logique NON ET.

Lorsque la fréquence F1 est sélectionnée, ce signal optique numérique 34 correspond à la fonction logique OU EXCLUSIF.

Enfin, lorsque la fréquence F2 est sélectionnée ce signal optique numérique 34 correspond à la fonction logique ET.

On dispose ainsi d'un générateur de fonction logique optique qui est remarquable par le fait que cette fonction logique est reconfigurable, c'est-à-dire peut être choisie parmi plusieurs fonctions logiques suivant la fréquence optique sélectionnée par le filtre optique accordable en fréquence 12.

Ce filtre optique accordable en fréquence 12 peut être un interféromètre de Perot Fabry accordable dont un exemple est schématiquement représenté sur la figure 6.

L'un, référencé 36, des deux miroirs de cet interféromètre de Perot Fabry 38 représenté sur la figure 6 est déplaçable en translation par rapport à l'autre miroir 40 de cet interféromètre 38.

Ce déplacement en translation permet de régler la distance entre les deux miroirs 36 et 40 et donc de sélectionner une fréquence optique parmi celles de la lumière incidente 26.

Le déplacement en translation est commandé par des moyens appropriés 42 comportant par exemple des câles piézoélectriques.

Le signal 34 qui sort de l'interféromètre 38 peut alors être détecté par une photodiode 43.

Dans un autre mode de réalisation particulier, le filtre optique accordable en fréquence 12 est constitué par une diode laser auxiliaire à contre-réaction distribuée 44 qui est schématiquement représentée sur la figure 7 et qui est polarisée au-dessous de son courant de seuil par des moyens appropriés 46.

Dans l'exemple représenté sur la figure 7, la diode laser auxiliaire 44 comporte deux électrodes de polarisation et c'est en réglant la valeur des courants de polarisation respectivement fournis par des moyens appropriés 46 que l'on choisit la valeur de la fréquence sélectionnée par cette diode laser auxiliaire 44 formant le filtre optique.

Au sujet d'une telle diode laser formant un filtre optique on pourra par exemple consulter le document suivant :

(3) Demande de brevet français n° 90 06 926 du 5 juin 1990, "Système de transmission bidirectionnelle à composants lasers identiques".

Le générateur de fonctions logiques optiques objet de la présente invention n'est pas limité à des fonctions logiques à deux entrées (cas de l'exemple représenté sur la figure 2).

On peut réaliser un générateur de fonctions logiques conforme à l'invention et capable d'engendrer des fonctions logiques à N entrées (c'est-à-dire à N variables logiques), N étant un nombre entier au moins égal à 2.

Dans ce cas, on utilise N diodes lasers du genre des diodes lasers LD1 et LD2, commandées comme ces dernières, ainsi qu'un coupleur optique à N entrées et une sortie.

Alors, les états de sortie de la diode laser LD3 se répartissent sur N fréquences optiques.

La présente invention permet de réaliser des portes logiques optiques dont la "vitesse" de fonctionnement (ou vitesse de commutation) est au moins égale à 1,5 GHz.

## TABLE DE VERITE

| LD1 | LD2 | FO | F1 | F2 |
|-----|-----|-----|-----|-----|
| 0 | 0 | 1 | 0 | 0 |
| 0 | 1 | 0 | 1 | 0 |
| 1 | 0 | 0 | 1 | 0 |
| 1 | 1 | 0 | 0 | 1 |

## Revendications

1. Générateur de fonctions logiques optiques, caractérisé en ce qu'il comprend :
   - une pluralité de sources (LD1, LD2) de signaux optiques numériques (S1, S2) qui sont synchrones et ont le même débit,
   - un coupleur optique (10) qui reçoit en entrée les signaux émis par les sources, mélange ceux-ci et fournit en sortie un signal optique résultant du mélange de ces signaux émis par les sources (S1, S2),
   - une diode laser à contre-réaction distribuée (LD3) qui a une ou deux électrodes de polarisation et dans la couche active de laquelle sont injectés simultanément les signaux optiques émis par les sources, par l'intermédiaire du coupleur optique (10),
   - des moyens (24) de polarisation électrique constante en courant, de cette diode laser (LD3), permettant à celle-ci de fournir en sortie un signal (26) dont la fréquence optique varie en fonction de la puissance lumineuse du signal injecté dans la diode laser (LD3), la diode laser fonctionnant dans un état mono mode,
   - un filtre optique (12) qui est accordable en fréquence et qui reçoit en entrée le signal fourni par la diode laser (LD3), et
   - des moyens (28) de commande du filtre optique (12), permettant à celui-ci de sélectionner l'une des fréquences optiques du signal de sortie de la diode laser (LD3) et de fournir ainsi un signal optique numérique (34) qui est une fonction logique des signaux (S1, S2) fournis par les sources (LD1, LD2).

2. Générateur selon la revendication 1, caractérise en ce que la direction de polarisation de chacun des signaux optiques numériques qui arrivent à l'entrée de la diode laser à contre-réaction distribuée (LD3) est dans le plan de polarisation de cette diode laser.

3. Générateur selon l'une quelconque des revendications 1 et 2, caractérisé en ce que la diode laser à contre-réaction distribuée (LD3) comporte deux électrodes de polarisation.

4. Générateur selon l'une quelconque des revendications 1 à 3, caractérisé en ce que le filtre optique (12) est un interféromètre de Perot Fabry accordable (38).

5. Générateur selon l'une quelconque des revendications 1 à 3, caractérisé en ce que le filtre optique (12) est une diode laser auxiliaire à contre-réaction distribuée (44) qui est munie de moyens (46) aptes à polariser cette diode laser auxiliaire (44) au dessous de son courant de seuil.

6. Générateur selon l'une quelconque des revendications 1 à 5, caractérisé en ce que le nombre de sources (LD1, LD2) de signaux optiques numériques (S1, S2) est égal à 2, la diode laser (LD3), qui reçoit ces signaux par l'intermédiaire du coupleur (10), émettant ainsi des signaux à trois fréquences optiques différentes (F0, F1, F2), le filtre optique (12) fournissant alors en sortie, suivant cette des trois fréquences qui est sélectionnée, l'une des fonctions logiques ET, NON ET et OU EXCLUSIF sous forme optique.


**Patentansprüche**

1. Generator zur Erzeugung optischer logischer Funktionen, **dadurch gekennzeichnet**, daß er umfaßt:
   - eine Vielzahl Quellen (LD1, LD2) von digitalen optischen Signalen (S1, S2), die synchron sind und dieselbe Leistung haben,
   - einen optischen Koppler (10), der als Eingang die durch die Qellen ausgesendeten Signale empfängt, diese mischt und als Ausgang ein aus der Mischung dieser durch die Quellen (S1, S2) resultierendes Signal liefert,
   - eine Laserdiode mit verteilter bzw. gesteuerter Rückkopplung (LD3), die eine oder zwei Polarisationselektroden aufweist und in deren aktive Schicht simultan die durch die Quellen ausgesendeten optischen Signale eingespeist werden, über den optischen Koppler (10),
   - elektrische Konstantstrom-Polarisationseinrichtungen (24) dieser Laserdiode (LD3), die dieser ermöglichen, als Ausgang ein Signal (26) zu liefern, dessen optische Frequenz variiert in Abhängigkeit von der Lichtleistung des in die Laserdiode (LD3) eingespeisten Signals, wobei die Laserdiode in einem Monomode- bzw. Eintypen-Zustand funktioniert, und
   - Steuereinrichtungen (28) des optischen Filters (12), die diesem ermöglichen, eine der optischen Frequenzen des Ausgangssignals der Laserdiode (LD3) auszuwählen und folglich ein digitales optisches Signal (34) zu liefern, das eine logische Funktion der durch die Quellen (LD1, LD2) gelieferten Signale (S1, S2) ist.

2. Generator nach Anspruch 1, dadurch gekennzeichnet, daß die Polarisationsrichtung eines jeden der digitalen optischen Signale, die am Eingang der Laserdiode mit verteilter Rückkopplung (LD3) eintreffen, in der Schwingungs- bzw. Polarisationsebene dieser Diode ist.

3. Generator nach einem der Ansprüche 1 und 2, dadurch gekennzeichnet, daß die Laserdiode mit verteilter Rückkopplung (LD3) zwei polarisationselektroden umfaßt.

4. Generator nach einem der Ansprüche 1 bis 3, dadurch gekennzeichnet, daß das optische Filter (12) ein abstimmbares Interferometer von Perot Fabry (38) ist.

5. Generator nach einem der Ansprüche 1 bis 3, dadurch gekennzeichnet, das das optische Filter (12) eine zusätzliche Laserdiode mit verteilter Rückkopplung (44) ist, ausgestattet mit Einrichtungen (46), die imstande sind, diese zusätzliche Laserdiode (44) unter ihrem Schwellenstrom zu polarisieren.

6. Generator nach einem der Ansprüche 1 bis 5, dadurch gekennzeichnet, daß die Anzahl der Quellen (LD1, LD2) von digitalen optischen Signalen (S1, S2) gleich 2 ist, wobei die Laserdiode (LD3), die diese Signale über den Koppler (10) empfängt, also Signale mit drei unterschiedlichen optischen Frequenzen (F0, F1, F2) aussendet und der optische Filter dann als Ausgang, entsprechend derjenigen der drei Frequenzen, die ausgewählt ist, eine der logischen Funktionen UND, NAND und ODER-EXKLUSIV liefert.

**Claims**

1. Optical logic function generator, characterized in that it comprises:
   - a plurality of sources (LD1, LD2) of digital optical signals (S1, S2), which are synchronous and have the same rate,
   - an optical coupler (10) receiving at the input the signals emitted by the sources, mixes them and supplies at the output an optical signal resulting from the mixing of said signals emitted by the sources (S1, S2),
   - a distributed feedback laser diode (LD3), which has one or two polarizing electrodes, into whose active layer are simultaneously injected the optical signals emitted by the sources, supplied by means of the optical couplers (10),
   - constant current means (24) for the electrical polarization of said laser diode (LD3) enabling the latter to supply at the output a signal (26), whose optical frequency varies as a function of the optical power of the signal injected into the laser diode (LD3), which functions in a monomode state,
   - an optical filter (12), which is frequency tunable and receives at the input the signal supplied by the laser diode (LD3) and
   - means (28) for the control of the optical filter (12) enabling the latter to select one of the optical frequencies of the output signal of the laser diode (LD3) and thus supply a digital optical signal (34), which is a logic function of the signals (S1, S2) supplied by the sources (LD1, LD2).

2. Generator according to claim 1, characterized in that the polarization direction of each of the digital optical signals reaching the input of the distributed feedback laser diode (LD3) is in the polarization plane of said laser diode.

3. Generator according to claim 1, characterized in that said distributed feedback laser diode (LD3) has two polarizing electrodes.

4. Generator according to claim 1, characterized in that the optical filter (12) is a tunable Perot Fabry interferometer (38).

5. Generator according to claim 1, characterized in that the optical filter (12) is an auxiliary distributed feedback laser diode (44), which is equipped with means (46) able to polarize said auxiliary laser diode (44) below its threshold current.

6. Generator according to claim 1, characterized in that the number of sources (LD1, LD2) of digital optical signals (S1, S2) is 2, the laser diode (LD3), which receives said signals via the coupler (10), thus emitting signals with three different optical frequencies (F0, F1, F2), the optical filter (12) then supplying at the output, as a function of which of the three frequencies is selected, one of the logic functions AND, NAND and EXCLUSIVE-OR in optical form.

FIG. 1

FIG. 6

FIG. 7

FIG. 2

EP 0 538 122 B1

FIG. 3

FIG. 4

FIG. 5